(19) **Europäisches Patentamt**

**European Patent Office**

**Office européen des brevets**

(11) **EP 0 496 637 B1**

(12) **EUROPEAN PATENT SPECIFICATION**

(45) Date of publication and mention of the grant of the patent:
**17.09.2003 Bulletin 2003/38**

(51) Int Cl.⁷: **H01L 29/47**

(21) Application number: **92300634.0**

(22) Date of filing: **24.01.1992**

(54) **High purity conductive films and their use in semiconductors**

Hochreine leitende Filme und ihre Anwendung in Halbleiteranordnungen

Films conducteurs de grande pureté et leur utilisation dans les semi-conducteurs

(84) Designated Contracting States:
**DE FR GB**

(30) Priority: **25.01.1991 JP 797291**

(43) Date of publication of application:
**29.07.1992 Bulletin 1992/31**

(73) Proprietor: **KABUSHIKI KAISHA TOSHIBA**
**Kawasaki-shi, Kanagawa-ken 210-8572 (JP)**

(72) Inventors:
 • **Ishigami, Takashi, c/o Intellectual Property Div.**
   **Minato-ku, Tokyo (JP)**
 • **Satou, Michio, c/o Intellectual Property Div.**
   **Minato-ku, Tokyo (JP)**
 • **Obata, Minoru, c/o Intellectual Property Div.**
   **Minato-ku, Tokyo (JP)**
 • **Miyauchi, Masami, c/o Intellectual Property Div.**
   **Minato-ku, Tokyo (JP)**
 • **Kawai, Mituo, c/o Intellectual Property Div.**
   **Minato-ku, Tokyo (JP)**
 • **Yamanobe, Takashi,**
   **c/o Intellectual Property Div.**
   **Minato-ku, Tokyo (JP)**
 • **Yagi, Noriaki, c/o Intellectual Property Div.**
   **Minato-ku, Tokyo (JP)**
 • **Maki, Toshihiro, c/o Intellectual Property Div.**
   **Minato-ku, Tokyo (JP)**
 • **Ando, Shigeru, c/o Intellectual Property Div.**
   **Minato-ku, Tokyo (JP)**
 • **Kohanawa, Yoshiko,**
   **c/o Intellectual Property Div.**
   **Minato-ku, Tokyo (JP)**

(74) Representative: **March, Gary Clifford et al**
**Batchellor, Kirk & Co.**
**102-108 Clerkenwell Road**
**London EC1M 5SA (GB)**

(56) References cited:
 **DE-A- 2 638 530**          **FR-A- 2 530 383**

 • **PATENT ABSTRACTS OF JAPAN vol. 015, no. 086 (E-1039) 28 February 1991 & JP-A-02 302 042 (SHARP CORP) 14 December 1990**
 • **PATENT ABSTRACTS OF JAPAN vol. 014, no. 431 (C-0759) 17 September 1990 & JP-A-02 166 276 (TOSHIBA CORP) 26 June 1990**
 • **PATENT ABSTRACTS OF JAPAN vol. 013, no. 024 (C-561) 19 January 1989 & JP-A-63 227 771 (TOSOH CORP) 22 September 1988**
 • **PATENT ABSTRACTS OF JAPAN vol. 009, no. 321 (E-367) 17 December 1985 & JP-A-60 154 614 (HITACHI SEISAKUSHO KK) 14 August 1985**

## Description

This invention relates to semiconductor devices comprising high purity conductive films, including films which contact barrier layers or gate electrodes.

In the contact section of semiconductor devices, a film, such as a Ti film, etc., is formed as a contact barrier layer between a silicon substrate and aluminum wires, to prevent diffusion of silicon into aluminum wires. Materials for such contact barrier layers are required to have characteristics including low electrical resistance, high heat resistance, and chemical stability needed for LSI manufacturing process steps. To meet the requirements for the contact barrier layer, applications of silicide films, high melting point metals, high melting point metal alloys or nitride films of Ti, Ta or Ti-W alloy have been considered, and some have been tried.

In accordance with a continuing advance of high integration techniques for semiconductor devices, such devices are continually becoming more downsized. According to the principle of scaling, it has been recognized that the vertical size of a semiconductor device is down-scaled at almost the same rate as the down-scaling of the horizontal size of the device. For example, according to this scaling principle, it is expected that the dept of each of the source and drain areas would become 0.1 to 0.15$\mu$m in a 16K-DRAM based on a design rule of 0.5$\mu$m. The leakage current of a field effect transistor has a tendency to increase as the depth of the source and drain areas becomes shallow. This is because the effect of impurities contained in the contact barrier layer disposed on the source and drain areas becomes relatively large in proportion to the decrease of the depth of the source and drain areas.

The leakage current of semiconductor devices causes malfunctions and reduced reliability. Therefore, it is desirable to minimize leakage current, especially as the down-scaling of semiconductor devices continues in the future.

The impurities listed below have been found in the contact barrier layers of semiconductor devices and are considered to be a source of adverse effects, so that efforts have been made to reduce their concentrations:

> a. Alkali metals such as Na, K, and the like. Such impurities are known to cause generation of an interface state.
> b. Radioactive elements such as U, Tb, and the like. Such impurities are known to cause soft errors in semiconductor devices.
> c. Heavy metals such as Fe, Cr, and the like. Such impurities are known to cause deterioration of interface characteristics in semiconductor devices.

With respect to the above reference to an interface state, Na and K are elements diffused easily in SiO$_2$ film. The elements move to the interface between a Si substrate and a SiO$_2$ gate insulating film. A portion of these elements are ionized resulting in positive charges, these charges generating the interface state. In this state, these charges tend to trap charge carriers in Si, such as the charge carriers flowing in the channel.

With respect to the above reference to causing soft error, when elements such as U and Th are present as impurities in contact barrier layer materials, their radioactive decay emits $\alpha$-rays. The $\alpha$-rays induce generation of electron-hole pairs which can cause a temporary malfunction referred to as "soft error."

With respect to the above reference to deterioration of interface characteristics, heavy metal impurities such as Fe, Cr, and the like are included in higher concentration than Na and K and also move to the interface between a Si substrate and a gate insulating layer made of SiO$_2$. The impurities cause the generation of an interface state and the fluctuation of threshold voltage.

Although impurity concentration varies as a function of the manufacturing process, materials for semiconductor devices typically contain about 1 x 10$^{19}$cm$^{-3}$ of each of the above-listed types of impurities. Some of these impurities are believed to act to increase leakage current in addition to such effects as generation of an interface state and deterioration of surface characteristics. Techniques known in the art have been successful in effecting reductions in leakage current. However, further reductions in leakage current will be required to improve device operation and to further control leakage current in view of the expected higher integration of semiconductor devices in the future.

On the other hand, low electrical resistance and high heat resistance are required for materials used for gate electrodes which form the gate section of semiconductor devices, while the application of metals with high melting points is under consideration for contact barrier layer materials. With the advancement of high integration of semiconductor devices, the depth of the source and drain areas becomes shallow, a distance between the gate electrode and the pn junction surface becomes short and a SiO$_2$ gate dielectric film thickness also becomes thin. As a result, impurities contained in the electrode material adversely affect the source and drain areas, inducing leakage current from a region where the gate electrode and the source and drain areas are in close proximity to each other via the SiO$_2$ gate film and the material for the contact barrier layer. Therefore, the possibility of increasing leakage current with the advancement of integration of semiconductor devices becomes high.

## SUMMARY OF THE INVENTION

Accordingly, it is an object of the invention to provide a semiconductor device including contact barrier layers, not subject to the aforementioned problems and disadvantages.

It is another object of the present invention to suppress or minimize leakage current in semiconductor devices by using silicide films, high melting point metals, high melting point metal alloys or nitride films of Ti, Ta or Ti-W for the contact barrier layer or gate electrode, in order to get high reliable semiconductor devices.

To accomplish the described objects, the present invention provides a semiconductor device including a contact barrier layer and/or a gate electrode either or both of which is constructed of high purity conductive film composed of conductive material whose impurity content of aluminium is $1 \times 10^{18}$ cm$^{-3}$.

The conductive film may comprise at least one material selected from Ti, W, Mo, Zr, Hf, Ta, V, Nb, Ir, Fe, Ni, Cr, Co, Pd, and Pt, and most preferably comprises at least one kind of metal silicide including a metal selected from Ti, Wi, Mo, Zr, Hf, Ta, V, Nb, Ir, Fe, Ni, Cr, Co, Pd and Pt or the film comprises a nitride of T, T, or Ti-W alloy.

Further, semiconductor devices constructed in accordance with the present invention are characterized by including the conductive films described above.

BRIEF DESCRIPTION OF THE DRAWINGS

The objects and advantage of the invention will become more apparent and more readily appreciated from the following detailed description of the presently preferred exemplary embodiments of the invention taken in conjunction with the accompanying drawings wherein:

Figure 1 to Figure 16 are graphs showing the leakage current characteristics for Al content in the contact barriers formed in diode devices;
Figure 17 is a vertical sectional view showing a structure of an embodiment according to the present invention; and
Figure 18 is a vertical sectional view showing a structure of another embodiment according to the present invention.

DESCRIPTION OF THE PREFERRED EMBODIMENTS

Leakage current in semiconductor devices is induced by the effect of impurities contained in materials for the contact barrier layer or gate electrode proximate the source and drain areas. The present invention is based, in part, on the discovery by the present inventors of the dependence of the magnitude of leakage current on the Al concentration in the contact barrier layer or gate electrode material.

Al was not regarded as a serious impurity in the prior art. However, the present inventors have discovered that Al contained in the conductive films, will segregate on an interface between the contact barrier layer and source electrode or drain electrode during a subsequent processing step during device fabrication.

Such Al reacts with oxygen left on the interface to form $Al_2O_3$. It also appears that the Al will form $Al_2O_3$ instead of deoxidizing a $SiO_2$ film in the device. These phenomena result in an increase of the contact resistance at the junction between an aluminum contact and the source or drain area. The inventors studied the relationships between the Al contents in conductive films and contact resistance, which are detected in the contact barrier layers. As the result, it was discovered that an increase of the contact resistance value by the formation of $Al_2O_3$ as described above is avoided by controlling the Al content of the conductive film to be below $1 \times 10^{18}$cm$^{-3}$.

Thus, in accordance with the present invention, the Al content in at least one of the contact barrier layer and the gate electrode of a semiconductor device is maintained at or below $1 \times 10^{18}$cm$^{-3}$ because if the Al content is above this value, leakage current will increase with the increase of Al content. Further, the semiconductor device becomes more susceptible to the effect of Al contained in the contact barrier layer with the decrease in the depth of the source and drain areas and leakage current will increase. However, if the Al content in at least one of the contact barrier layer and the gate electrode of a semiconductor device is maintained at or below $1 \times 10^{18}$cm$^{-3}$, leakage current will be kept at nearly a constant level regardless of the depth of the source and drain areas.

The conductive films made of TiN, Mo, W, $TiSi_2$ and $CoSi_2$ of the present invention are preferred for practical use because they have excellent thermal stability as well as chemical stability. Furthermore, such films have an effect to reduce contact resistance when used for the contact barrier layer.

The conductive film of the present invention is effective for reducing leakage current in a semiconductor device irrespective of whether the film and device are constructed of either crystalline or amorphous material. In general, thermal stability in the amorphous state is less satisfactory, however such metals as Ta-Ir, Ni-Nb, Fe-W, etc., are relatively stable and can be successfully used in the amorphous state. Since such amorphous alloys have no grain boundary, Al does not diffuse at a high speed and, as a result, the leakage current is restrained further.

The conductive film of the present invention can be produced, for example, in the following manner. During fabrication of a semiconductor device, while forming a high purity contact barrier layer or a gate electrode film consisting of a high melting point metal or a high melting point alloy film, a silicide film or a Ti, Ta, W T-W alloy nitride film, the sputtering method, which is generally used for forming the conductive film of semiconductor devices, is used. In this case, the Al content in the conductive film is suppressed by reducing the Al concentration in the sputtering target.

The Al content in the resulting conductive film directly corresponds to the Al content in the sputtering target. For example, to suppress the Al content in a Ti-W alloy or Mo silicide film to below $1 \times 10^{18}$ cm$^{-3}$, the Al content in a Ti-W alloy sputtering target or Mo silicide sputtering target is suppressed to below 30 ppm. The conductive film is produced by sputtering using these kinds of targets. In addition, it is also possible to suppress the Al content in the conductive film deposited by sputtering and composed of at least one of a high melting point metal, high melting point metal alloy, and metal silicide to $1 \times 10^{18}$ cm$^{-3}$ or below by use of a sputtering target having an Al concentration suppressed to below 30 ppm.

With respect to conductive films composed of nitrides of Ti, Ta, W, and Ti-W alloys, the Al content in the conductive film can be suppressed to below $1 \times 10^{18}$ cm$^{-3}$ by performing the active sputtering in a nitrogen gas atmosphere with the Al content in a Ti, Ta, W, or Ti-W alloy target suppressed to below 30 ppm.

Further, as previously described, it is also necessary to thoroughly reduce the concentration of heavy metal elements and alkali metals because they tend to move to the surface of a laminated film and deteriorate the surface characteristic or cause junction leaks.

The conductive film of the present invention is also formed using the chemical vapor deposition (CVD) method. In this case, the Al content in the film can be suppressed to a low level by reducing the Al concentration in the gas used to perform the CVD.

Several embodiments of semiconductor devices including a contact barrier layer in accordance with the present invention are described next with respect to the exemplary device illustrated in Figure 17. In particular, Fig. 17 illustrates a semiconductor diode 10 comprising an n-type silicon substrate 3, a p$^+$ area 2 formed in the surface of substrate 3, and an insulating layer 5 of SiO$_2$ formed on the substrate. An aperture 6 formed in the layer 5 exposes a portion of the p$^+$ area 2 on which is deposited a contact barrier layer 1. An Al contact layer 4 is deposited over the contact barrier layer 1.

The diode 10 was produced to have structure similar to that of the contact section of a MOSFET device. The depth of p$^+$ area 2 is similar to the depth of the source or drain area of a MOSFET constructed in accordance with the same design rule. Specific device dimensions are provided below.

Embodiment 1

A diode was produced by forming the contact barrier layer 1 made of Ti-W on the p$^+$ area 2 formed on the n type substrate 3 and by forming the Al layer 4 on the contact barrier layer 1 as shown in Figure 17. The depth of the source and drain areas of this diode was about 0.3μm and the area of the aperture 6 was 1.5 x 1.5μm$^2$.

The contact barrier layer was formed by the following steps:

A high purity W powder (maximum particle size of 10μm or below, mean particle size of 4μm) was mixed for 48 hours with a high purity Ti powder (maximum particle size of 50μm or below, mean particle size of 30μm) in the ratio of 10 wt% Ti-W (i.e., 10 wt% Ti and 90 wt% W) using a ballmill filled with high purity Ar gas. A BN mold release was spread on a surface of a mold made of graphite and a Ta-plate was put on the surface of the mold. The mold was then filled with the mixed powder.

Next, the mold was inserted in a hot-press machine and the mixed powder in the mold was compacted and sintered for 3 hours under conditions of $5 \times 10^{-4}$ Torr, 1400°C, and a pressure of 250kg/cm$^2$.

The sintered body was shaped by machining to form a first target having approximate dimensions of 260mm diameter and 6mm thickness. The Al content of the target was approximately 0.8 ppm.

A second target was produced in a manner similar to that described above, except without use of the Ta-plate on the mold. The Al content of the second target was 15 ppm.

A high purity W powder (maximum particle size of 50μm or below, mean particle size of 30μm) was mixed for 48 hours with a high purity Ti powder (maximum particle size of 100μm or below, mean particle size of 70μm) in the ratio of 10 wt% Ti-W using a ballmill filled with high purity Ar gas. A third target was produced from this mixed powder in the manner described above without a Ta-plate in a mold. The Al content of the third target was 50 ppm.

Three devices 10 were formed. The contact barrier layer 1 in each of the three devices was formed as a Ti-W film using *a* different one of the first, second, and third targets described above.

The Al content in each of Ti-W films was measured by frameless atomic absorption spectrophotometry. The values of the Al content of the films formed using the first, second, and third targets were $1 \times 10^{17}$ cm$^{-3}$, $1 \times 10^{18}$ cm$^{-3}$ and $1 \times 10^{19}$ cm$^{-3}$, respectively.

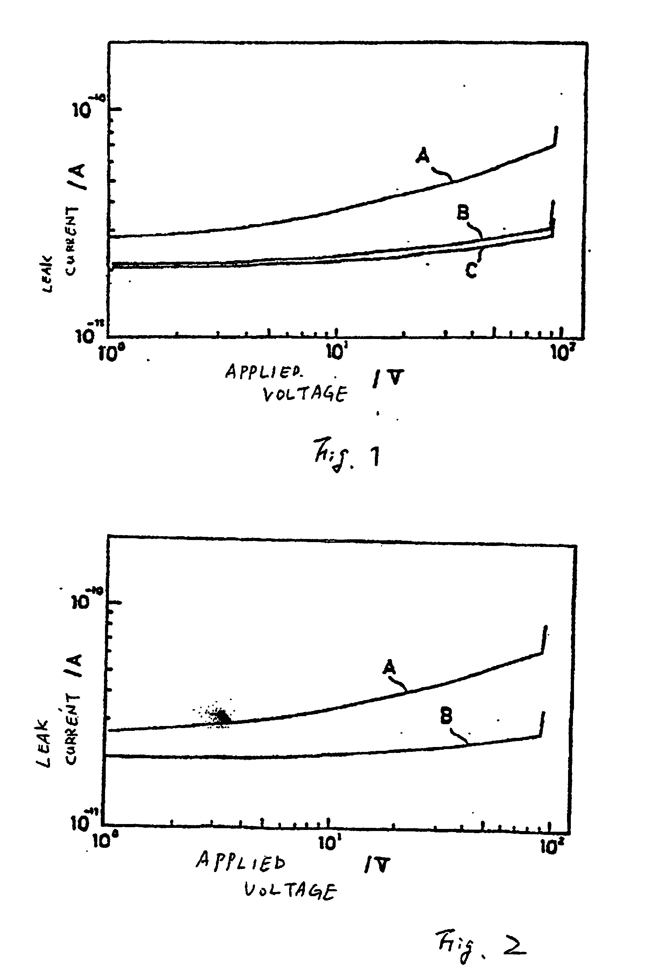

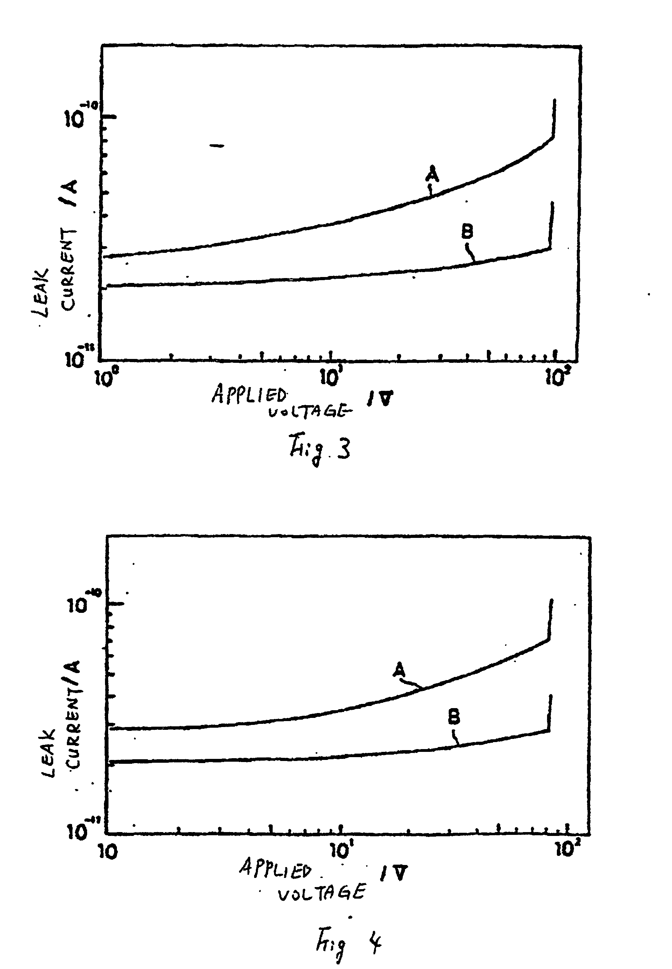

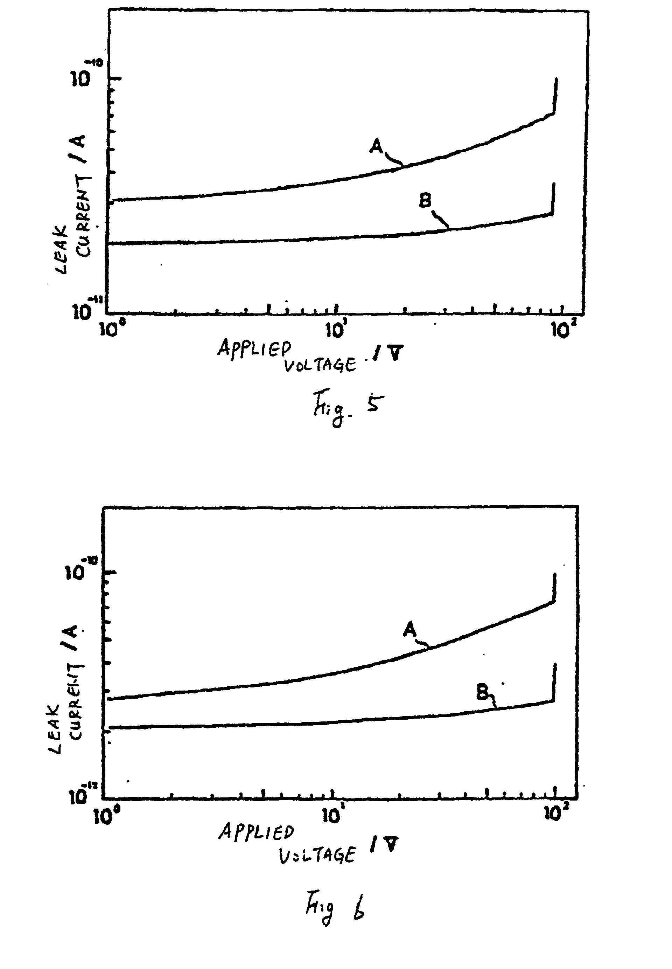

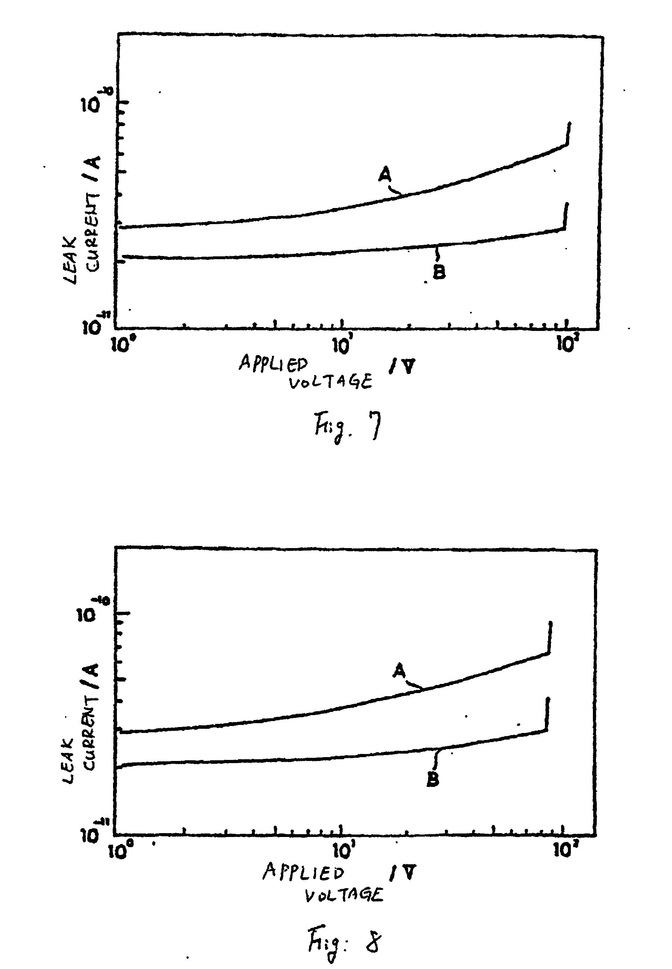

The thickness of layer 1 was about 80 nm. The relation between the Al content in the Ti-W contact barrier layer and pn junction leakage current was also evaluated. A reverse bias voltage was applied to each diode. The reverse bias voltage was initially 0V and was gradually increased. The leakage current of each diode was measured until breakdown occurred. The results of this investigation are plotted on the graph shown in Figure 1. The abscissa represents the applied reverse bias voltage and the ordinate represents the measured leakage current.

In Figure 1, Curve A shows the current-voltage characteristic of the diode with a Ti-W layer having an Al content of $1 \times 10^{19}$ cm$^{-3}$. Curve B corresponds to the diode with a Ti-W layer having an Al content of $1 \times 10^{18}$ cm$^{-3}$. Curve C corresponds to the diode with a Ti-W layer having an Al content of $1 \times 10^{17}$ cm$^{-3}$. With respect to the Ti-W layers in all three devices, the content of impurities other than aluminum was sufficiently low. In particular, the total content of heavy metals other than Al, Ti, and W was below $5 \times 10^{16}$ cm$^{-3}$ and the total con-

tent of alkali metals was below $5 \times 10^{16} \text{cm}^{-3}$. As seen in Figure 5, the leakage current values of Curves B and C remain almost unchanged over the range of applied voltage. However, Curve A shows a substantial increase in leakage current. Since the concentrations of other harmful impurities were sufficiently low, the increase of leakage current is attributed to the increase in Al content. Therefore, the leakage current is suppressed substantially by reducing the Al content in the contact barrier layer.

Embodiment 2

Two diodes 10 were constructed, each having a Mo contact barrier layer 1, with all other features of the diode having the same construction as in Embodiment 1. The relation between the Al content in the Mo contact barrier layer and the pn junction leakage current was investigated. The Mo contact barrier layers of the two diodes were respectively formed according to the CVD method using $MoCl_5$ gas having an Al concentration below 0.1 ppm with a very small quantity (about 500 ppm) of Al added and $MoCl_5$ gas having an Al concentration below 0.1 ppm. The Al contents of these two Mo films were $3 \times 10^{18} \text{cm}^{-3}$ and $3 \times 10^{17} \text{cm}^{-3}$, respectively, when measured by frameless atomic absorption spectrophotometry.

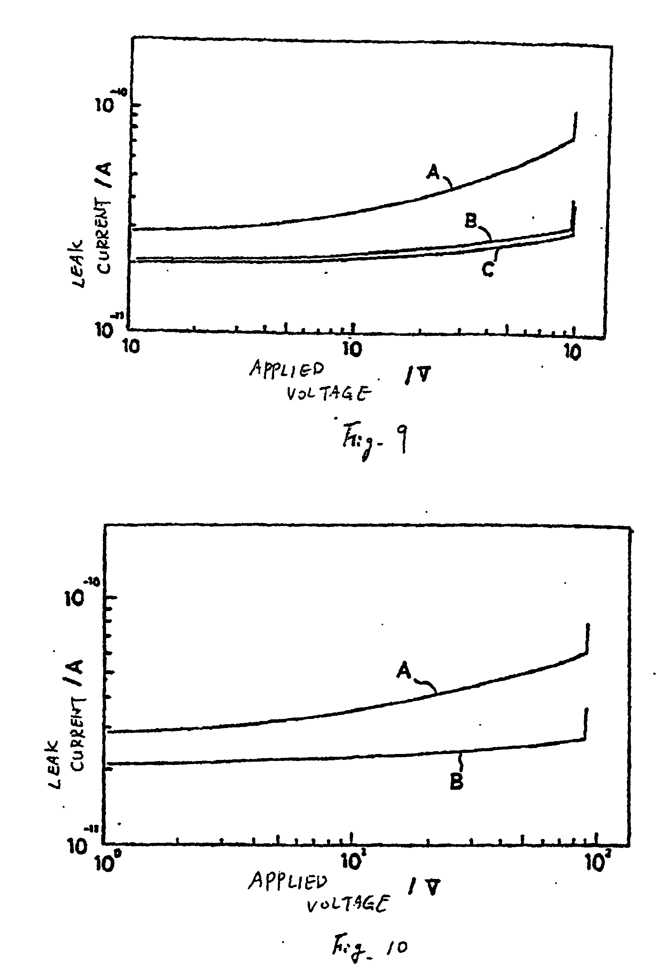

Further, the thickness of the Mo layer in each device was about 100 nm. The measurement of leakage current was conducted according to the same method as in Embodiment 1. The results of measurement of the pn junction leakage current value as a function of reverse bias voltage are shown in Figure 2. In Figure 2, Curve A shows the current-voltage characteristic of a diode including the Mo contact barrier layer with an Al content of $3 \times 10^{18} \text{cm}^{-3}$ and Curve B shows the current-voltage characteristic of the diode having the Mo layer with an Al content of $3 \times 10^{17} \text{cm}^{-3}$. In both Mo layers, the total content of heavy metal elements other than Mo was low, i.e., below $1 \times 10^{17} \text{cm}^{-3}$ and the total content of alkali metals was also low, i.e., below $3 \times 10^{16} \text{cm}^{-3}$. As clearly seen from Figure 2, leakage current is suppressed substantially by reducing the Al content in the contact barrier layer.

Embodiment 3

Two diodes were constructed, each having a W contact barrier layer 1 with all other features of the diodes having the same construction as in Embodiment 1. The relation between the Al content in the W contact barrier layer and pn junction leakage current was investigated. The W contact barrier layers of the two diodes were respectively formed according to the CVD method using 0.1 ppm or less $WF_6$ gas with a very small quantity of Al (60 ppm) added and $WF_6$ gas with an Al concentration of 0.1 ppm.

The Al contents of these two W layers were 0.5 $\times 10^{19} \text{cm}^{-3}$ and $4 \times 10^{17} \text{cm}^{-3}$, respectively, when measured by frameless atomic absorption spectrophotometry. Further, the thickness of the W layer in each device was about 80 nm. The measurement of leakage current was conducted in the same manner as in Embodiment 1. The results of measurement of the pn junction leakage current value as a function of reverse bias voltage are shown in Figure 3. Curve A in Figure 3 shows the current-voltage characteristics of the diode having the W layer with an Al content of $0.5 \times 10^{19} \text{cm}^{-3}$ and Curve B shows that of the diode having the W layer with an Al content of $4 \times 10^{17} \text{cm}^{-3}$.

In both W layers, the content of heavy metal other than W was sufficiently low, i.e., below $1 \times 10^{17} \text{cm}^{-3}$ and the content of alkali metal was also low, i.e., below $3 \times 10^{16} \text{cm}^{-3}$. As clearly seen from Figure 3, the leakage current is suppressed substantially by reducing the Al concentration in the contact barrier layer.

Embodiment 4

Two diodes 10 were constructed, each having a Ta-Ir amorphous contact barrier layer 1, with all other features of the diode having the same construction as in Embodiment 1. The relation between the Al content in the Ta-Ir amorphous contact barrier layer and the pn junction leakage current was investigated. The Ta-Ir amorphous contact barrier layers of the two diodes were respectively formed by sputtering using 48.5 wt% Ta-Ir composite targets respectively having Al concentrations of 100 and 30 ppm. When measured by frameless atomic absorption spectrophotometry, the Al contents of the respective layers were $8 \times 10^{18} \text{cm}^{-3}$ and $4 \times 10^{17} \text{cm}^{-3}$. The contact barrier layer thickness was about 90 nm in each diode. The measurement of leakage current was conducted in the same manner as in Embodiment 1.

The results of measurement of the pn junction leakage current values as a function of reverse bias voltage are shown in Figure 4. Curve A in Figure 4 shows the current-voltage characteristic of the diode having the Ta-Ir layer with an Al content of $8 \times 10^{18} \text{cm}^{-3}$ and Curve B shows the characteristic of the diode having the Ta-Ir layer with an Al content of $4 \times 10^{17} \text{cm}^{-3}$. In both Ta-Ir layers, the content of heavy metal elements other than Ta was low, i.e., below $1 \times 10^{17} \text{cm}^{-3}$ and the content of alkali metals was low, i.e., below $0.5 \times 10^{16} \text{cm}^{-3}$. As clearly seen from Figure 4, leakage current is suppressed substantially by reducing the Al content in the contact barrier layer.

Embodiment 5

Two diodes were constructed, each having an Ni-Nb amorphous contact barrier layer 1, with all other features of the diode having the same construction as in Embodiment 1. The relation between the Al content in the Ni-Nb amorphous contact barrier layer and the pn junction leakage current was investigated. The Ni-Nb amorphous contact barrier layers of the two diodes were respectively formed using 61 wt% Ni-Nb composite targets with Al concentrations of 180 and 10 ppm, respectively. When measured by frameless atomic absorption spectrophotometry, the Al content in each Ni-Nb amorphous contact barrier layer was $1.5 \times 10^{19} cm^{-3}$ and $1 \times 10^{17} cm^{-3}$. The layer thickness was about 90 nm. The measurement of leakage current was conducted in the same manner as in Embodiment 1.

The results of measurement of the pn junction leakage current value as a function of reverse bias voltage are shown in Figure 5. Curve A in Figure 5 shows the current-voltage characteristic of the diode having the Ni-Nb layer with an Al content of $1.5 \times 10^{19} cm^{-3}$ and Curve B shows the diode having the Ni-Nb layer with an Al content of $1 \times 10^{17} cm^{-3}$. In both Ni-Nb layers, the content of heavy metal elements other than Ni and Nb was low, i.e., below $1 \times 10^{17} cm^{-3}$ and the content of alkali metal was low, i.e., below $3 \times 10^{16} cm^{-3}$. As clearly seen from Figure 5, leakage current is suppressed substantially by reducing the Al content in the contact barrier layer.

Embodiment 6

Two diodes 10 were constructed, each having a Fe-W amorphous contact barrier layer 1, with all other features of the diode having the same construction as in Embodiment 1. The relation between the Al content in the Fe-W amorphous contact barrier layer and the pn junction leakage current was investigated. The Fe-W amorphous contact barrier layers of the two diodes were respectively formed by sputtering using 23.3 wt% Fe-W composite targets having Al concentrations of about 150 and 15 ppm, respectively. When measured by frameless atomic absorption spectrophotometry, the Al contents of the respective Fe-W amorphous contact barrier layers were $2.6 \times 10^{18} cm^{-3}$ and $1 \times 10^{17} cm^{-3}$. The contact barrier layer thickness was about 90 nm in each diode. The measurement of leakage current was conducted in the same manner as in Embodiment 1.

The results of measurement of the pn junction leakage current values as a function of reverse bias voltage are shown in Figure 6. Curve A in Figure 6 shows the current-voltage characteristic of the diode having the Fe-W layer with an Al content of $2.6 \times 10^{18} cm^{-3}$ and Curve B shows the characteristic of the diode having the Fe-W layer with an Al content of $1 \times 10^{17} cm^{-3}$. In both Fe-W layers, the content of heavy metal elements other than Fe and W was below $1 \times 10^{17} cm^{-3}$ and the content of alkali metal was below $0.5 \times 10^{16} cm^{-3}$. As clearly seen from Figure 6, leakage current is suppressed substantially by reducing the Al content in the contact barrier layer.

Embodiment 7

Two diodes 10 were constructed, each having a Ti silicide contact barrier layer 1, with all other features of the diode having the same construction as in Embodiment 1. The relation between the Al content in the Ti silicide contact barrier layer and the pn junction leakage current was investigated. The Ti silicide contact barrier layers of the two diodes were respectively formed according to the sputtering method using 56.0 wt% Ti-Si composite targets with Al concentrations of 150 and 15 ppm, respectively.

A Ti-Si composite target (Al content 150 ppm) was produced by the following process. A quantity of Ti made by the Kroll process was melted by arc discharge to form a Ti ingot of 140mm diameter. The Ti ingot was hot-forged, grinded, polished, and shaped to form a Ti sputtering target.

Then Si-blocks (purity 5N) were uniformly spaced apart on the Ti target surface in a checkerboard-like mosaic pattern to cover approximately 56% of the area of the Ti target. The Al content in each Si-block was 1 ppm or less.

A Ti-Si composite target (Al content 10 ppm) was produced by the following process. An electrode made of sponge Ti was immersed into an electrolytic bath (KCl:16 wt%, NaCl: 84 wt%) and formed into Ti needles by the molten salt electrolysis method at conditions of 755°C, current 200A, and voltage 8V.

Then the Ti needles were washed in a NaOH solution, to remove Al on the surface of the needles, and rinsed in water. After that, the Ti needles were melted by the electron beam melting method under conditions of $5 \times 10^{-5}$ mbar and 30kW and a Ti ingot of 135mm diameter was formed. The Ti ingot was cool-forged, grinded, polished, and shaped to form a Ti target.

Then Si-blocks (purity 5N) were uniformly spaced apart on the Ti target surface in a checkerboard-like mosaic pattern to cover approximately 56% of the area of the Ti target. The Al content in each Si-block was 1 ppm or less.

Using these targets (Al content 150 ppm, 10 ppm), the Ti silicide layers were produced by the sputtering method and the Al contents in the layers were $5 \times 10^{18} cm^{-3}$ and $1 \times 10^{17} cm^{-3}$, respectively, measured by frameless atomic absorption spectrophotometry. The layer thickness was about 90 nm in each diode. The measurement of leakage current was conducted in the same manner as in Embodiment 1.

The results of measurement of the pn junction leakage current values as a function of reverse bias voltage are shown in Figure 7. Curve A in Figure 7 shows the current-voltage characteristic of the diode having the Ti silicide layer with an Al content of $5 \times 10^{18} cm^{-3}$ and Curve B shows the characteristic of the diode having the Ti silicide layer with an Al content of $1 \times 10^{17} cm^{-3}$. In both Ti-silicide layers, the content of heavy metal elements other than Ti was below $2 \times 10^{17} cm^{-3}$ and the content of alkali metals was below $1 \times 10^{16} cm^{-3}$. As clearly seen from Figure 7, leakage current is suppressed substantially by reducing the Al content in the contact barrier layer.

Embodiment 8

Two diodes 10 were constructed, each having a W-silicide contact barrier layer 1, with all other features of the diode having the same construction as in Embodiment 1. The relation between the Al content in the W-silicide contact barrier layer and the pn junction leakage current was investigated. The W-silicide contact barrier layers of the two diodes were respectively formed according to the sputtering method using 70.8 wt% W-Si composite targets having Al concentrations of about 150 and 0.3 ppm, respectively.

The W-silicide targets were produced by the following process.

High purity W powder (maximum particle size of $10\mu m$ or less) was mixed for 48 hours with high purity Si powder (maximum particle size of $30\mu m$ or below) in the ratio of 70.8 wt% W-Si using a ballmill filled with high purity Ar gas.

A BN mold release was spread on a surface of a mold made of graphite and a Ta-plate was put on the surface of the mold. Then the mold was filled with the mixed powder.

Next, the mold was inserted in a hot-press machine and the mixed powder was changed to silicide under conditions of under $5 \times 10^{-4}$ Torr, $1250°C$ for 2 hours, and pressure of 50 kg/cm$^2$. Then the silicide was deoxidized and decarbonized under conditions of $135°C$ for 5 hours and was compacted and sintered under conditions of $1400°C$ for 5 hours and pressure of 270 kg/cm$^2$ to form a sintered body.

The sintered body was grinded, polished, and shaped by electrospark machining to form a first target of approximately 260mm diameter and 6mm thickness. The Al content in the first target was 0.3 ppm.

Si powder (Al content 450 ppm) was mixed for 48 hours with high purity W powder (maximum particle size $10\mu m$ or less) in the ratio of 70.8 wt% W-Si using a ballmill filled with high purity Ar gas. Using this mixed powder, a second target was produced in a similar manner to that described above for producing the first target. The Al content of the second target was 150 ppm.

When measured by frameless atomic absorption spectrophotometry, the Al contents of the respective W-silicide layers were $2.5 \times 10^{18}$cm$^{-3}$ and $1 \times 10^{16}$cm$^{-3}$, respectively. The layer thickness was about 90 nm in each diode. The measurement of leakage current was conducted in the same manner as in Embodiment 1.

The results of measurement of the pn junction leakage current values of each diode as a function of the reverse bias voltage are shown in Figure 8. Curve A in Figure 8 shows the current-voltage characteristic of the diode having the W-silicide layer with an Al content of $2.5 \times 10^{18}$cm$^{-3}$ and Curve B shows the characteristic of the diode having the W-silicide layer with an Al content of $1 \times 10^{16}$cm$^{-3}$. In both W-silicide layers, the content of heavy metal elements other than W was low, i. e., below $1 \times 10^{17}$cm$^{-3}$ and the content of alkali metals was low, i.e., below $3 \times 10^{16}$cm$^{-3}$. As clearly seen from Figure 8, leakage current is suppressed substantially by reducing the Al content of the contact barrier layer.

Embodiment 9

Two diodes 10 were constructed, each having a Mo-silicide contact barrier layer 1, with all other features of the diode having the same construction as in Embodiment 1. The relation between the Al content in the Mo-silicide contact barrier layer and the pn junction leakage current was investigated. The Mo-silicide contact barrier layer was formed according to the sputtering method using 63.1 wt% No-Si composite targets having Al concentrations of about 150, 30 and 0.4 ppm, respectively.

The Mo-silicide targets were produced by the following process.

High purity Mo powder (maximum particle size was $10\mu m$ or below) was mixed for 48 hours with high purity Si powder (maximum particle size of $30\mu m$ or below) in the ratio of 63.1 wt% Mo-Si using a ballmill filled with high purity Ar gas.

A BN mold release was spread on a surface of a mold made of graphite and a Ta-plate was put on the surface of the mold. Then the mold was filled with the mixed powder.

Next, the mold was inserted in a hot-press machine and the mixed powder was changed to silicide under conditions of under $5 \times 10^{-4}$ Torr, $1100°C$ for 2 hours, and pressure of 40 kg/cm$^2$. Then the silicide was deoxidized and decarbonized under conditions of $1350°C$ for 5 hours and was compacted and sintered under conditions of $1400°C$ for 5 hours and pressure of 280 kg/cm$^2$ to form a sintered body.

The sintered body was grinded, polished, and shaped by electrospark machining to form a first target of approximately 260mm diameter and 6mm thickness. The Al content in the first target was 0.4 ppm.

Si powder (Al content 120 ppm for a second target) or Si powder (Al content 450 ppm for a third target) was mixed for 48 hours with high purity W powder (maximum particle size $10\mu m$ or below) in the ratio of 63.1 wt% Mo-Si using a ballmill filled with high purity Ar gas. Using these mixed powders, second and third targets were produced in a similar manner to that described above for the first target. The Al contents in the second and third targets were 150 ppm and 330 ppm, respectively.

When measured by frameless atomic absorption spectrophotometry, the Al contents of the respective W-silicide layers were $2 \times 10^{19}$cm$^{-3}$ and $1 \times 10^{18}$cm$^{-3}$ and $1 \times 10^{16}$cm$^{-3}$, respectively. The layer thickness was about 90 nm in each diode. The measurement of leakage current was conducted in the same manner as in Embodiment 1.

The results of measurement of the pn junction leakage current values of each diode as a function of the reverse bias voltage are shown in Figure 9. Curve A in Figure 9 shows the current-voltage characteristic of the diode having the W-silicide layer with an Al content of $2 \times 10^{19} cm^{-3}$, Curve B shows the characteristic of the diode having the W-silicide layer with an Al content of $1 \times 10^{18} cm^{-3}$, and Curve C shows the characteristic of the diode having the W-silicide layer with an Al content of $1 \times 10^{16} cm^{-3}$. In all three films, the content of heavy metal elements other than Mo was low, i.e., below $5 \times 10^{16} cm^{-3}$ and the content of alkali metals was below $5 \times 10^{16} cm^{-3}$. As clearly seen from Figure 9, leakage current is suppressed substantially by reducing the Al content of the contact barrier layer.

Embodiment 10

Two diodes 10 were constructed, each having a Ta-silicide contact barrier layer 1, with all other features of the diode having the same construction as in Embodiment 1. The relation between the Al content in the Ta-silicide contact barrier layer and the pn junction leakage current was investigated. The Ta-silicide contact barrier layers of the two diodes were respectively formed according to the sputtering method using 76.3 wt% Ta-Si composite targets having Al concentrations of about 150 ppm and 0.4 ppm, respectively.

The Ta-silicide targets were produced by the following process.

High purity Ta powder (maximum particle size of 10μm or below) was mixed for 48 hours with high purity Si powder (maximum particle size of 30μm or below) in the ratio of 76.31 wt% Ta-Si using a ballmill filled with high purity Ar gas.

A BN mold release was spread on a surface of a mold made of graphite and a Ta-plate was put on the surface of the mold. Then the mold was filled with the mixed powder.

Next, the mold was inserted in a hot-press machine and the mixed powder was changed to silicide under conditions of under $5 \times 10^{-4}$ Torr, 1150°C for 3 hours, and pressure of 60 kg/cm$^2$. Then the silicide was deoxidized and decarbonized under conditions of 1300°C for 5 hours and was compacted and sintered under conditions of 1360°C for 5 hours and pressure of 280 kg/cm$^2$ to form a sintered body.

The sintered body was grinded, polished and shaped by electrospark machining to form a first target of approximately 260mm diameter and 6mm thickness. The Al content of the first target was 0.4 ppm.

Si powder (Al content 430 ppm) was mixed for 48 hours with high purity Ta powder (maximum particle size 10μm or below) in the ratio of 76.3 wt% Ta-Si using a ballmill filled with high purity Ar gas. Using this mixed powder, a second target was produced in a similar manner to that described above. The Al content of the second target were 150 ppm.

When measured by frameless atomic absorption spectrophotometry, the Al contents of the respective Ta-silicide layers were $4 \times 10^{18} cm^{-3}$ and $2 \times 10^{17} cm^{-3}$, respectively. The layer thickness was about 90 nm in each diode. The measurement of leakage current was conducted in the same manner as in Embodiment 1.

The results of measurement of the pn junction leakage current values of each diode as a function of the reverse bias voltage are shown in Figure 10. Curve A in Figure 10 shows the current-voltage characteristic of the diode having the Ta-silicide layer with an Al content of $4 \times 10^{18} cm^{-3}$ and Curve B shows the characteristic of the diode having the Ta-silicide layer with an Al content of $2 \times 10^{16} cm^{-3}$. In both layers, the content of heavy metal elements other than Ta was low, i.e., below $2 \times 10^{16} cm^{-3}$ and the concentration of alkali metals was low, i.e., below $0.5 \times 10^{16} cm^{-3}$. As clearly seen from Figure 10, leakage current is suppressed substantially by reducing the Al content of the contact barrier layer.

Embodiment 11

Two diodes were constructed, each having an Ni-silicide contact barrier layer 1, with all other features of the diode having the same construction as in Embodiment 1. The relation between the Al content in the Ni-silicide contact barrier layer and the pn junction leakage current was investigated. The Ni-silicide contact barrier layers of the two diodes were respectively formed according to the sputtering method using 51.1 wt% Ni-Si composite targets having Al concentrations of about 200 and 0.5 ppm, respectively.

The Ni-silicide targets were produced by the following process.

High purity Ni powder (maximum particle size of 10μm or less) was mixed for 48 hours with high purity Si powder (maximum particle size of 30μm or less) in the ratio of 51.1 wt% Ni-Si using a ballmill filled with high purity Ar gas.

A BN mold release was spread on a surface of a mold made of graphite and a Ta-plate was put on the surface of the mold. Then the mold was filled with the mixed powder.

Next, the mold was inserted in a hot-press machine and the mixed powder was changed to silicide under conditions of under $5 \times 10^{-4}$ Torr, 750°C for 3 hours, and pressure of 50 kg/cm$^2$. Then the silicide was deoxidized and decarbonized under conditions of 900°C for 5 hours and was compacted and sintered under conditions of 940°C for 5 hours and pressure of 280 kg/cm$^2$ to form a sintered body.

The sintered body was grinded, polished and shaped by electrospark machining to form a first target of approximately 260mm diameter and 6mm thickness. The Al content in the first target was 0.4 ppm.

Si powder (Al content 400 ppm) was mixed for 48 hours with high purity Ni powder (maximum particle size 10μm or less) in the ratio of 51.1 wt% Ni-Si using a ballmill filled with high purity Ar gas. Using this mixed powder, a second target was produced in a similar manner to that described above for producing the first target. The Al content of the second target was 200 ppm.

When measured by frameless atomic absorption spectrophotometry, the Al contents of the respective Ni-silicide layers were $8 \times 10^{18} cm^{-3}$ and $3 \times 10^{16} cm^{-3}$, respectively. The layer thickness was about 90 nm in each diode. The measurement of leakage current was conducted in the same manner as in Embodiment 1.

The results of measurement of the pn junction leakage current values of each diode as a function of the reverse bias voltage are shown in Figure 11. Curve A in Figure 11 shows the current-voltage characteristic of the diode having the Ni-silicide layer with an Al content of $8 \times 10^{18} cm^{-3}$ and Curve B shows the characteristic of the diode having the Ni-silicide layer with an Al content of $3 \times 10^{16} cm^{-3}$. In both Ni-silicide layers, the content of heavy metal elements other than Ni was low, i.e., below $2 \times 10^{17} cm^{-3}$ and the content of alkali metals was low, i.e., below $1 \times 10^{16} cm^{-3}$. As clearly seen from Figure 11, leakage current is suppressed substantially by reducing the Al content of the contact barrier layer.

Embodiment 12

Two diodes 10 were constructed, each having a Co-silicide contact barrier layer 1, with all other features of the diode having the same construction as in Embodiment 1. The relation between the Al content in the Co-silicide contact barrier layer and the pn junction leakage current was investigated. The Co-silicide contact barrier layers of the two diodes were respectively formed according to the sputtering method using 51.2 wt% Co-Si composite targets having Al concentrations of about 200 and 0.6 ppm, respectively.

The Co-silicide targets were produced by the following process.

High purity Co powder (maximum particle size of 10μm or less) was mixed for 48 hours with high purity Si powder (maximum particle size of 30μm or less) in the ratio of 51.2 wt% Co-Si using a ballmill filled with high purity Ar gas.

A BN mold release was spread on a surface of a mold made of graphite and a Ta-plate was put on the surface of the mold. Then the mold was filled with the mixed powder.

Next, the mold was inserted in a hot-press machine and the mixed powder was changed to silicide under conditions of under $5 \times 10^{-4}$ Torr, 1000°C for 3 hours, and pressure of 40 kg/cm². Then the silicide was deoxidized and decarbonized under conditions of 1150°C for 5 hours and was compacted and sintered under conditions of 1240°C for 5 hours and pressure of 280 kg/cm² to form a sintered body.

The sintered body was grinded, polished and shaped by electrospark machining to form a first target of approximately 260mm diameter and 6mm thickness.

The Al content in the first target was 0.6 ppm.

Si powder (Al content 320 ppm) was mixed for 48 hours with high purity Co powder (maximum particle size 10μm or less) in the ratio of 51.2 wt% Co-Si using a ballmill filled with high purity Ar gas. Using this mixed powder, a second target was produced in a similar manner to that described above for the first target. The Al content of the second target was 160 ppm.

When measured by frameless atomic absorption spectrophotometry, the Al contents of the respective Co-silicide layers were $0.5 \times 10^{19} cm^{-3}$ and $2 \times 10^{16} cm^{-3}$, respectively. The layer thickness was about 80 nm in each diode. The measurement of leakage current was conducted in the same manner as in Embodiment 1.

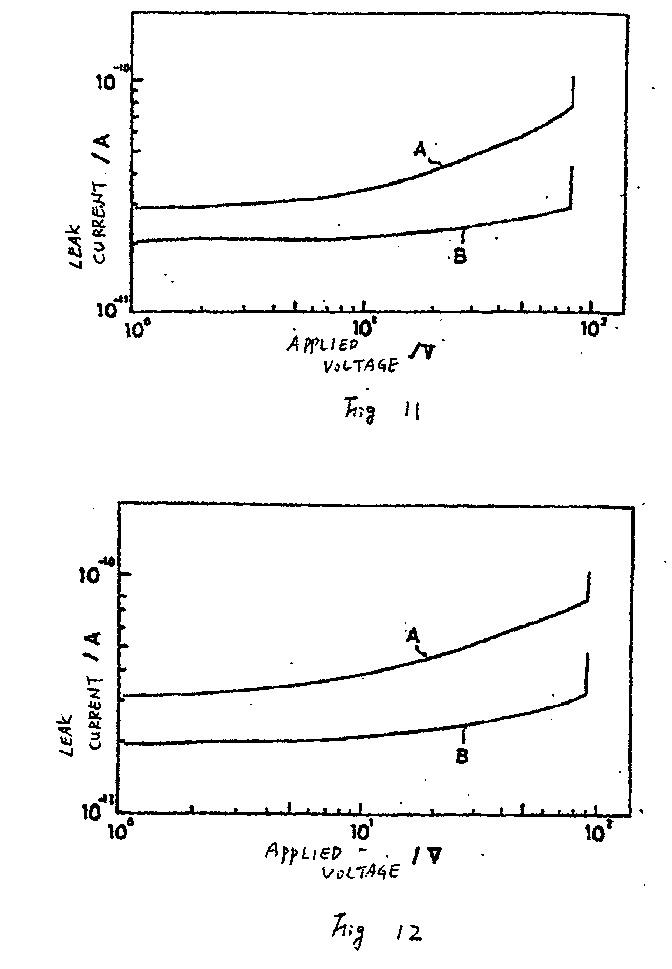

The results of measurement of the pn junction leakage current values of each diode as a function of the reverse bias voltage are shown in Figure 12. Curve A in Figure 12 shows the current-voltage characteristic of the diode having the Co-silicide layer with an Al content of $0.5 \times 10^{19} cm^{-3}$ and Curve B shows the characteristic of the diode having the Co-silicide layer with an Al content of $2 \times 10^{16} cm^{-3}$. In both Co-silicide layers, the content of heavy metal elements other than Co was low, i.e., below $2 \times 10^{17} cm^{-3}$ and the content of alkali metals was low, i.e., below $1 \times 10^{16} cm^{-3}$. As clearly seen from Figure 12, leakage current is suppressed substantially by reducing the Al content of the contact barrier layer.

Embodiment 13

Three diodes 10 were constructed, each having a Ti-nitride contact barrier layer 1, with all other features of the diode having the same construction as in Embodiment 1. The relation between the Al content in the Ti-nitride contact barrier layer and the pn junction leakage current was investigated. The Ti-nitride contact barrier layers of the three diodes were respectively formed according to the sputtering method in a nitrogen atmosphere using Ti targets having Al concentrations of about 150, 10, and 3, respectively.

A first Ti target (Al content 150 ppm) and a second Ti target (Al content 10 ppm) were produced by the same method as described for embodiment 7. Each of these targets was machined to a circular shape approximately four inches in diameter.

A third Ti target (Al content 3 ppm) was produced in the following manner.

The Ti needles were produced in the same way as described in embodiment 7.

Then, the Ti needles were washed in a NaOH solution, to remove Al on the surfaces of the needles, and rinsed in water.

Moreover, these needles were dipped for 3 minutes in a mixed solution consisting of hydrofluoric acid, nitric acid, hydrochloric acid and water (2:1:1:196 in wt%, respectively).

After that, these Ti needles were melted by the electron beam melting method under the same conditions of embodiment 7 and a Ti ingot of 135mm diameter was formed. The Ti ingot was cool-forged and grinded, polished, and shaped to form a circular Ti target approximately four inches in diameter.

Air in a chamber of a direct current dipole magnetron sputtering apparatus was evacuated to a pressure of $1 \times 10^{-6}$ Torr. Next, the chamber was filled with a gas of 50% Ar-50% $N_2$ at a pressure of $5 \times 10^{-3}$ Torr. Then one of the Ti targets was placed in the chamber. The film was formed by sputtering of the target using a 400 watt direct current power supply.

When measured by frameless atomic absorption spectrophotometry, the Al contents of the respective Ti-nitride layers were $1 \times 10^{19} cm^{-3}$, $1 \times 10^{18} cm^{-3}$ and $1 \times 10^{17} cm^{-3}$, respectively. Further, the layer thickness was about 100 nm in each diode. The measurement of leakage current was conducted in the same manner as in Embodiment 1.

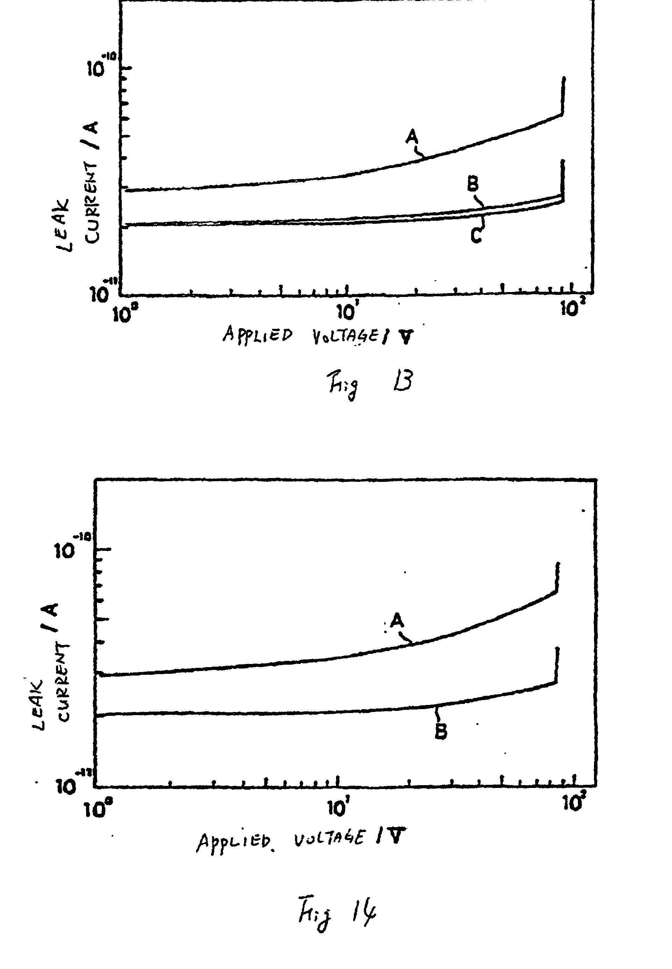

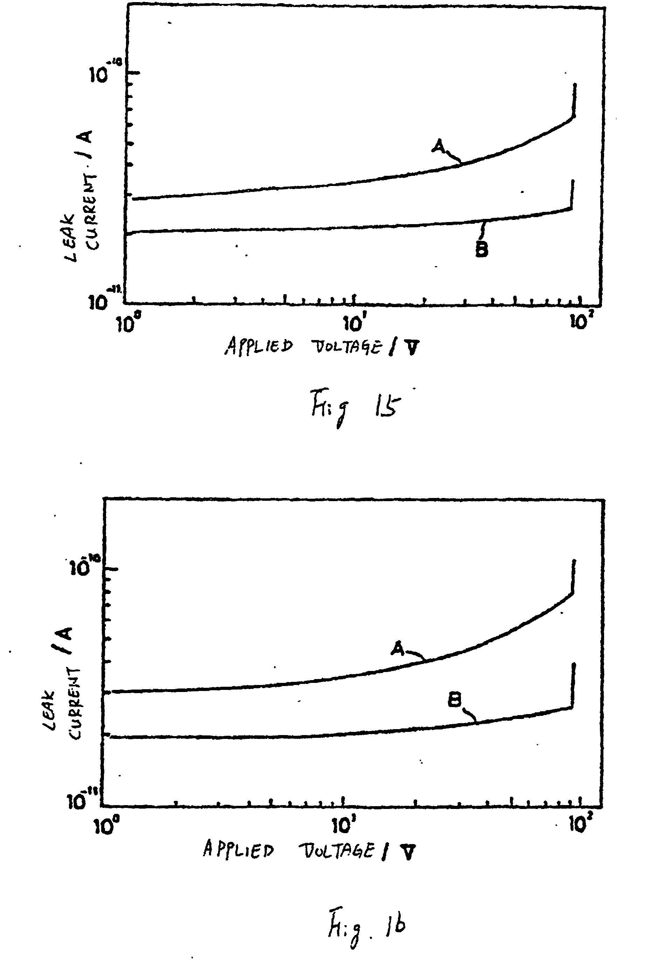

The results of measurement of the pn junction leakage current values of each diode as a function of the reverse bias voltage are shown in Figure 13. Curve A in Figure 13 shows the current-voltage characteristic of the diode having the Ti-nitride layer with an Al content of $1 \times 10^{19} cm^{-3}$, Curve B shows the characteristic of the diode having the Ti-nitride layer with an Al content of $1 \times 10^{18} cm^{-3}$, and Curve C shows the characteristic of the diode having the Ti-nitride layer with an Al content of $1 \times 10^{17} cm^{-3}$. In all Ti-nitride layers, the content of heavy metal elements other than Ti was low, i.e., below $5 \times 10^{16} cm^{-3}$ and the content of alkali metals was low, i.e., below $5 \times 10^{16} cm^{-3}$. As clearly seen from Figure 13, leakage current is suppressed substantially by reducing the Al content of the contact barrier layer.

Embodiment 14

Two diodes 10 were constructed, each having a Ta-nitride contact barrier layer 1, with all other features of the diode having the same construction as in Embodiment 1. The relation between the Al content in the Ta-nitride contact barrier layer and the pn junction leakage current was investigated. The Ta-nitride contact barrier layers of the two diodes were respectively formed in a nitrogen atmosphere according to the sputtering method using Ta targets having Al concentrations of about 150 and 1 ppm, respectively.

Sputtering was conducted as described above for Embodiment 13, except that 350 watts of direct current power was used.

When measured by frameless atomic absorption spectrophotometry, the Al contents of the respective Ta-nitride contact barrier layers were $4 \times 10^{18} cm^{-3}$ and $1 \times 10^{17} cm^{-3}$, respectively. The layer thickness was about 80 nm in each diode. The measurement of leakage current was conducted in the same manner as in Embodiment 1.

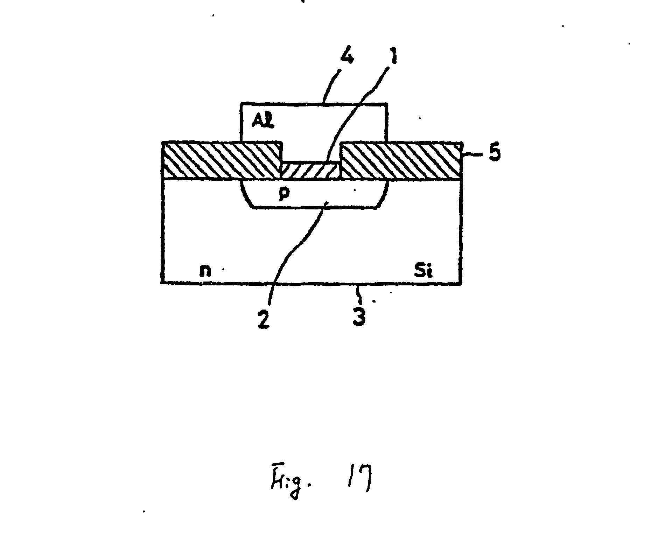

The results of measurement of the pn junction leakage current values of each diode as a function of reverse bias voltage are shown in Figure 14. Curve A in Figure 14 shows the current-voltage characteristic of the diode having the Ta-nitride layer with an Al content of $4 \times 10^{18} cm^{-3}$ and Curve B shows the characteristic of the diode having the Ta-nitride layer with an Al content of $1 \times 10^{17} cm^{-3}$. In both Ta-nitride layers, the content of heavy metal elements other than Ta was low, i.e., below $1 \times 10^{17} cm^{-3}$ and the content of alkali metals was low, i. e., below $3 \times 10^{16} cm^{-3}$. As clearly seen from Figure 14, leakage current is suppressed substantially by reducing the Al content in the contact barrier layer.

Embodiment 15

Two diodes 10 were constructed, each having a Ti-W nitride contact barrier layer 1, with all other features of the diode having the same construction as in Embodiment 1. The relation between the Al content in the Ti-W nitride contact barrier layer and the pn junction leakage current was investigated. The Ti-W nitride contact barrier layer was formed in a nitrogen atmosphere according to the sputtering method using 10 wt% Ti-W composite targets having Al concentrations of about 200 and 1 ppm, respectively.

Sputtering was conducted as described above for Embodiment 13, except that 420 watts of direct current power was used.

When measured by frameless atomic absorption spectrophotometry, the Al contents of the respective Ti-W nitride layers were $5 \times 10^{18} cm^{-3}$ and $2 \times 10^{17} cm^{-3}$, respectively. The contact barrier layer thickness was about 80 nm in each diode. The measurement of leakage current was conducted in the same manner as in Embodiment 1.

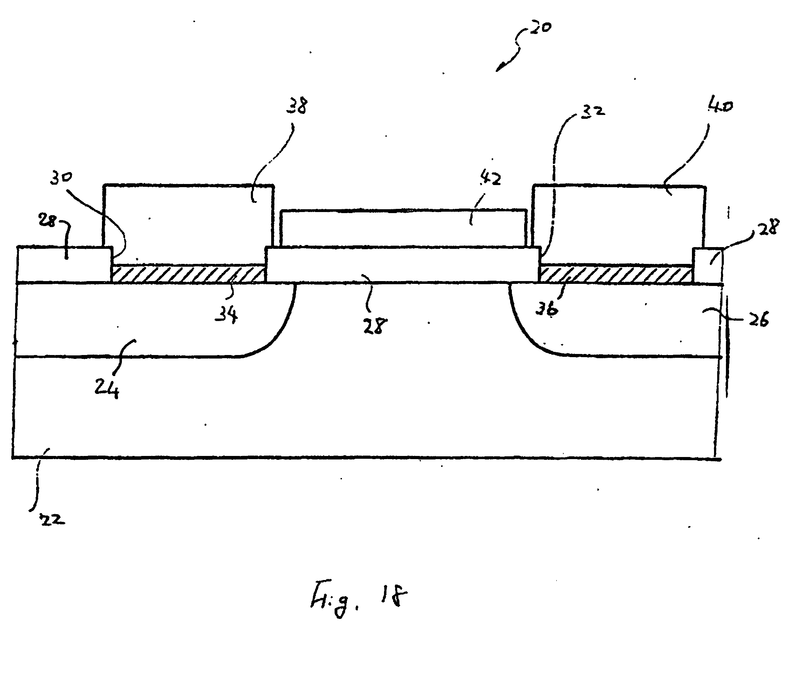

The results of measurement of the pn junction leakage current values of each diode as a function of reverse bias voltage are shown in Figure 15. Curve A in Figure 15 shows the current-voltage characteristic of the diode having the Ti-W nitride layer with an Al content of $5 \times 10^{18} cm^{-3}$ and Curve B shows the characteristic of the diode having the Ti-W nitride layer with an Al content of $2 \times 10^{17} cm^{-3}$. In both Ti-W nitride layers, the content of heavy metal elements other than Ti was low, i.e., below $2 \times 10^{17} cm^{-3}$ and the content of alkali metals was low, i.e., below $1 \times 10^{16} cm^{-3}$. As clearly seen from Figure 15, leakage current is suppressed substantially by reducing the Al content in the contact barrier layer.

Embodiment 16

Two diodes 10 were constructed, each having a W-nitride contact barrier layer 1, with all other features of the diode having the same construction as in Embodiment 1. The relation between the Al content in the W-nitride contact barrier layer and the pn junction leakage current was investigated. The W-nitride contact barrier layers of the two diodes were respectively formed in a nitrogen atmosphere according to the sputtering method using W targets having Al concentrations of about 170 and 1 ppm, respectively.

Sputtering was conducted as described above for Embodiment 13, except that 450 watts of direct current power was used.

When measured by frameless atomic absorption spectrophotometry, the Al contents of the W-nitride contact barrier layers were $3 \times 10^{18} \text{cm}^{-3}$ and $1 \times 10^{17} \text{cm}^{-3}$, respectively. The layer thickness was about 90 nm in each diode. The measurement of leakage current was conducted in the same manner as in Embodiment 1.

The results of measurement of the pn junction leakage current values of each diode as a function of reverse bias voltage are shown in Figure 16. Curve A in Figure 16 shows the current-voltage characteristic of the diode having the w-nitride layer with an Al content of $3 \times 10^{18} \text{cm}^{-3}$ and Curve B shows the characteristic of the diode having the W-nitride layer with an Al content of $1 \times 10^{17} \text{cm}^{-3}$. In both W-nitride layers, the content of heavy metal elements other than W was low, i.e., below $1 \times 10^{17} \text{cm}^{-3}$ and the content of alkali metals was low, i. e., below $1 \times 10^{16} \text{cm}^{-3}$. As clearly seen from Figure 16, leakage current is suppressed substantially by reducing the Al content in the contact barrier layer.

Fig. 18 illustrates a MOSFET 20 having a conventional construction except for the composition of its gate electrode and contact barrier layers, which are constructed in accordance with the present invention. MOSFET 20 includes substrate 22 of a first conductivity type. A source area 24 and a drain area 26 are each of a second conductivity type, opposite the first conductivity type, and are diffused into a major surface of substrate 22. An insulating film 28 is deposited on the major surface of substrate 22 and includes apertures 30 and 32 which expose portions of source area 24 and drain area 26. Contact barrier layers 34 and 36 are respectively deposited over the portions of source area 24 and drain area 26 exposed by apertures 30 and 32. Aluminum wires 38 and 40 are respectively connected to contact barrier layers 34 and 36 to thereby effect conductive contact to source area 24 and drain area 26. A gate electrode 42 is deposited over a portion of insulating film 28 overlying the area between the source and drain areas.

In accordance with the present invention, gate electrode 42 and each of contact barrier layers 34 and 36 are composed of any one of the above described conductive film materials in which the aluminum content is maintained at or below $1 \times 10^{18} \text{cm}^{-3}$. As a result, the leakage current of MOSFET 20 can be kept at a nearly constant level as the device is down-sized, regardless of the depth of the source and drain areas.

The present invention has been described with respect to specific embodiments. However, other embodiments based on the principles of the present invention should be obvious to those of ordinary skill in the art. Such embodiments are intended to be covered by the claims.

**Claims**

1. A semiconductor device including a contact barrier layer and/or a gate electrode either or both of which is constructed of high purity conductive film composed of conductive material whose impurity content of:

    (i) aluminium is $\leq 1 \times 10^{18} \text{ cm}^{-3}$.

2. A semiconductor device as claimed in claim 1 whose impurity content of (ii) heavy metals is $< 1 \times 10^{17} \text{ cm}^{-3}$ and whose impurity content of (iii) alkali metals is $< 5 \times 10^{16} \text{ cm}^{-3}$ in said gate electrode and/ or contact barrier layer.

3. A semiconductor device as claimed in either preceding claim including both contact barrier layer and gate electrode both of which are constructed from said conductive material.

4. A semiconductor device as claimed in any preceding claim wherein the conductive material is composed of at least one kind of material comprising one or more of the following: Ti, W, Mo, Zr, Hf, Ta, V, Nb, Ir, Fe, Ni, Cr, Co, Pd and Pt.

5. A semiconductor device as claimed in claim 4 wherein the said one kind of material is metallic silicide of one or more of the metallic elements defined in claim 4.

6. A semiconductor device as claimed in claim 4 wherein the said one kind of material is nitride of one or more of the following: Ti, W, Ta, and alloys of Ti and W.

7. A semiconductor device as claimed in any preceding claim comprising:

    a substrate of a first conductivity type and having a surface;
    a region of a second conductivity type opposite the first conductivity type and formed in the surface of the substrate;
    an insulating layer disposed on the surface of the substrate, the insulating layer including an aperture exposing at least a portion of the second conductivity type region;
    a contact barrier layer disposed on the portion of the second conductivity type region exposed by the aperture; and
    a contact layer composed of a first conductive material disposed at least on the contact barrier layer;

    wherein the contact barrier layer is composed of a second conductive material as defined in any preceding claim.

8. A semiconductor device as claimed in any one of claims 1 to 6 further comprising:

a substrate of a first conductivity type and having a major surface;

a source region of a second conductivity type opposite the first conductivity type and formed in the major surface of the substrate;

a drain region of the second conductivity type formed in the major surface of the substrate at a location spaced apart from the source region;

an insulating layer disposed on a portion of the major surface of the substrate, the insulating layer including apertures exposing at least a portion of the source region and a portion of the drain region;

a contact barrier layer disposed on the respective portions of the source and drain regions exposed by the apertures;

a contact layer composed of a first conductive material disposed at least on each contact barrier layer; and

an electrode disposed on the insulating layer over a portion of the major surface of the substrate between the source and drain regions;

wherein the contact barrier layer and the electrode are each composed of conductive material as defined in any one of claims 1 to 6.

9. A semiconductor device according to any preceding claim which is a diode.

10. A semiconductor device according to any one of claims 1 to 8 which is a MOSFET device.

**Patentansprüche**

1. Halbleitervorrichtung mit einer Kontaktbarriereschicht und/oder einer Gate-Elektrode, von denen eine oder beide aus einem hochreinen leitenden Film bestehen, der sich aus einem leitenden Material zusammensetzt, das einen Verunreinigungsgehalt von:

(i) Aluminium $\leq 1 \times 10^{18}$ cm$^{-3}$

aufweist.

2. Halbleitervorrichtung nach Anspruch 1, deren Verunreinigungsgehalt von (ii) Schwermetallen $< 1 \times 10^{17}$ cm$^{-3}$ ist und deren Verunreinigungsgehalt von (iii) Alkalimetallen $< 5 \times 10^{16}$ cm$^{-3}$ in der Gate-Elek-

trode und/oder Kontaktbarriereschicht ist.

3. Halbleitervorrichtung nach einem der vorhergehenden Ansprüche, mit der Kontaktbarriereschicht und der Gate-Elektrode, wobei beide sich aus dem leitenden Material zusammensetzen.

4. Halbleitervorrichtung nach einem der vorhergehenden Ansprüche, wobei das leitende Material zusammengesetzt ist aus mindestens einer Materialart, die sich aus einem oder mehreren der folgenden Elemente zusammensetzt: Ti, W, Mo, Zr, Hf, Ta, V, Nb, Ir, Fe, Ni, Cr, Co, Pd und Pt.

5. Halbleitervorrichtung nach Anspruch 4, wobei eine Materialart metallisches Silicid aus einem oder mehreren der metallischen in Anspruch 4 definierten Elemente ist.

6. Halbleitervorrichtung nach Anspruch 4, wobei eine Materialart ein Nitrid einer oder mehrerer der folgenden Materialien ist: Ti, W, Ta, und Legierungen von Ti und W.

7. Halbleitervorrichtung nach einem der vorhergehenden Ansprüche, mit:

einem Substrat aus einem ersten Leitfähigkeitstyp und mit einer Oberfläche;

einem Bereich eines zweiten Leitfähigkeitstyps, der dem ersten Leitfähigkeitstyp entgegengesetzt ist und in der Oberfläche des Substrates gebildet ist;

einer Isolationsschicht, die auf der Oberfläche des Substrates angeordnet ist, wobei die Isolationsschicht eine Öffnung aufweist, die wenigstens einen Teil des zweiten Leitfähigkeitstypbereichs freigibt;

einer Kontaktbarriereschicht, die auf dem Teil des zweiten Leitfähigkeitstypbereichs angeordnet und durch die Öffnung freigegeben ist; und

einer Kontaktschicht, die sich aus einem ersten leitenden Material zusammensetzt, das wenigstens an der Kontaktbarriereschicht angeordnet ist;

wobei die Kontaktbarriereschicht sich zusammensetzt aus einem zweiten leitenden Material, das in einem der vorhergehenden Ansprüche definiert ist.

8. Halbleitervorrichtung nach einem der Ansprüche 1 bis 6, weiterhin aufweisend:

ein Substrat eines ersten Leitfähigkeitstyps mit einer Hauptoberfläche;

eine Sourceregion eines zweiten Leitfähigkeitstyps, entgegengesetzt dem ersten Leitfähigkeitstyp und in der Hauptoberfläche des Substrates gebildet;

eine Drainregion des zweiten Leitfähigkeitstyps, die in der Hauptoberfläche des Substrates an einer Örtlichkeit gebildet ist, die von der Sourceregion beabstandet ist;

eine Isolationsschicht, die auf einem Abschnitt der Hauptoberfläche des Substrates angeordnet ist, wobei die Isolationsschicht Öffnungen aufweist, die wenigstens einen Teil der Sourceregion und einen Teil der Drainregion freigeben;

eine Kontaktbarriereschicht, die auf den entsprechenden Bereichen der Source- und Drainregionen angeordnet ist und durch die Öffnungen freigegeben wird;

eine Kontaktschicht, die zusammengesetzt ist aus einem ersten leitfähigen Material, das wenigstens an jeder Kontaktbarriereschicht angeordnet ist; und

eine Elektrode, die an der Isolationsschicht über einem Bereich der Hauptoberfläche des Substrates zwischen den Source- und Drainregionen angeordnet ist;

wobei die Kontaktbarriereschicht und die Elektrode jeweils zusammengesetzt sind aus leitfähigem Material, das in einem der Ansprüche 1 bis 6 definiert ist.

9. Halbleitervorrichtung nach einem der vorhergehenden Ansprüche, wobei diese eine Diode ist.

10. Halbleitervorrichtung nach einem der Ansprüche 1 bis 8, wobei diese eine MOSFET-Vorrichtung ist.

**Revendications**

1. Dispositif à semi-conducteur comprenant une couche de transition de contact et/ou une électrode grille, l'une ou les deux étant fabriquée (s) à l'aide d'un film conducteur d'une très grande pureté composé d'un matériau conducteur dont la concentration en impureté est pour :

(i) l'aluminium ≤ 1 x 10$^{18}$ cm$^{-3}$.

2. Dispositif à semi-conducteur selon la revendication 1, dont la concentration en impureté pour les (ii) métaux lourds est < 1 x 10$^{17}$ cm$^{-3}$ et dont la concentration en impureté pour les (iii) métaux alcalins est < 5 x 10$^{16}$ cm$^{-3}$ dans ladite électrode grille et/ou la couche de transition de contact.

3. Dispositif à semi-conducteur selon l'une des deux revendications précédentes concernant à la fois une couche de transition de contact et une électrode grille fabriquées toutes les deux à partir dudit matériau conducteur.

4. Dispositif à semi-conducteur selon l'une quelconque des revendications précédentes dans lequel le matériau conducteur est composé d'au moins un type de matériau comprenant un ou plusieurs des métaux suivants : Ti, W, Mo, Zr, Hf, Ta, V, Nb, Ir, Fe, Ni, Cr, Co, Pd et Pt.

5. Dispositif à semi-conducteur selon la revendication 4, dans lequel ledit type de matériau est le siliciure métallique composé d'un ou plusieurs des éléments métalliques définis dans la revendication 4.

6. Dispositif à semi-conducteur selon la revendication 4, dans lequel ledit type de matériau est le nitrure composé d'un ou plusieurs des métaux suivants : Ti, W, Ta, et des alliages de Ti et W.

7. Dispositif à semi-conducteur selon l'une quelconque des revendications précédentes, comprenant :

un substrat d'un premier type de conductibilité et possédant une surface ;
une zone d'un second type de conductibilité opposée au premier type de conductibilité et formée dans la surface du substrat ;
une couche isolante placée sur la surface du substrat, la couche isolante comprenant une ouverture exposant au moins une partie de la zone du second type de conductibilité ;
une couche de transition de contact placée sur la partie de la zone du second type de conductibilité exposée par l'ouverture ; et
une couche de contact composée d'un premier matériau conducteur placée au moins sur la couche de transition de contact ;

dans lequel la couche de transition de contact est composée d'un second matériau conducteur ainsi que défini dans l'une quelconque des revendications précédentes.

8. Dispositif à semi-conducteur selon l'une quelconque des revendications 1 à 6, comprenant en outre :

un substrat d'un premier type de conductibilité et possédant une surface principale ;
une zone source d'un second type de conductibilité opposée au premier type de conductibilité et formée dans la surface principale du substrat ;
une zone drain du second type de conductibilité formée dans la surface principale du substrat à un emplacement distant de la zone source ;

une couche isolante placée sur une partie de la surface principale du substrat, la couche isolante comprenant des ouvertures exposant au moins une partie de la zone source et une partie de la zone drain ;

une couche de transition de contact placée sur les parties respectives des zones source et drain exposées par les ouvertures ;

une couche de contact composée d'un premier matériau conducteur placé au moins sur chaque couche de transition ; et

une électrode placée sur la couche isolante sur une partie de la surface principale du substrat entre les zones source et drain ;

dans lequel la couche de transition de contact et l'électrode sont chacune composée de matériau conducteur tel que défini dans l'une quelconque des revendications 1 à 6.

9. Dispositif à semi-conducteur selon l'une quelconque des revendications précédentes qui est une diode.

10. Dispositif à semi-conducteur selon l'une quelconque des revendications 1 à 8 qui est un transistor à effet de champ MOS.

Fig. 1

Fig. 2

Fig. 3

Fig. 4

EP 0 496 637 B1

Fig. 5

Fig 6

Fig. 7

Fig: 8

Fig. 9

Fig. 10

Fig 11

Fig 12

Fig 13

Fig 14

Fig 15

Fig. 16

Fig. 17

Fig. 18